# FASCICULE DE BREVET EUROPEEN

(11) **EP 0 635 886 B1**
(45) Date de publication et mention de la délivrance du brevet: **24.02.1999**
(21) Numéro de dépôt: 94410050.2
(22) Date de dépôt: 19.07.1994
(51) Int. Cl.: H01L 27/07, H01L 27/08, H02H 9/04

(54) **Composant monolithique comprenant une diode de protection en parallèle avec une pluralité de paires de diodes en série, et utilisations de ce composant**
Monolitisches Bauelement mit einer Schutzdiode, die mit einer Vielzahl von seriell geschalteten Diodenpaaren parallelgeschaltet ist, und dessen Verwendungen
Monolithic device including a protection diode connected in parallel to a plurality of diode pairs connected in series, and uses thereof

(30) Priorité: 21.07.1993 FR 9309250
(43) Date de publication de la demande: 25.01.1995
(73) Titulaire: STMicroelectronics S.A., 94250 Gentilly (FR)
(72) Inventeur: Pezzani, Robert, F-37210 Vouvray (FR)
(74) Mandataire: de Beaumont, Michel

(56) Documents cités:
- EP-A- 0 318 404
- US-A- 3 617 864
- PATENT ABSTRACTS OF JAPAN vol. 12, no. 24 (E-576) 23 Janvier 1988 & JP-A-62 179 756 (SANYO) 6 Août 1987

## Description

La présente invention concerne les circuits de protection et plus particulièrement les réseaux de diodes utilisés pour la protection de paires différentielles de lignes téléphoniques numériques ou de systèmes informatiques.

Dans les systèmes informatiques, on trouve souvent des connecteurs auxquels sont reliés un grand nombre de lignes dont le potentiel est susceptible de varier entre des premier et deuxième états correspondant à des première et deuxième tensions.

On considérera ci-après plus particulièrement le cas où la première tension est la masse et où la deuxième tension est une tension positive, par exemple +5 volts. Mais il sera clair que plus généralement les tensions de ces lignes peuvent varier entre une tension haute et une tension basse ou tension de référence.

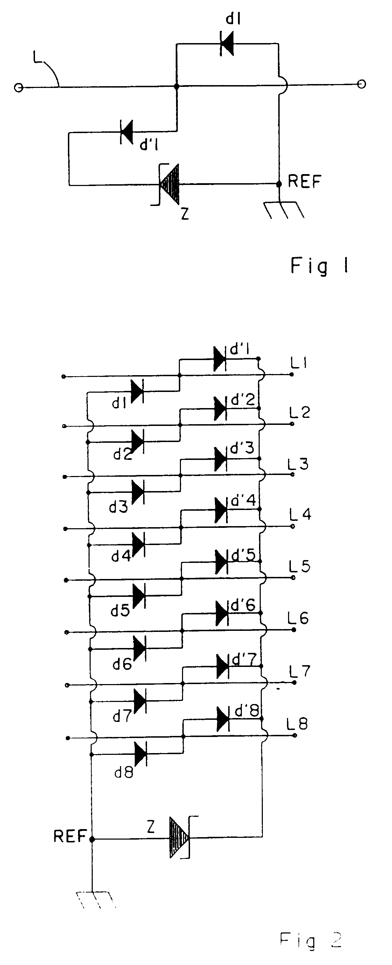

Un schéma de protection classique pour une ligne de ce type est illustré en figure 1. La ligne L est reliée à la tension de référence REF (la masse) par l'intermédiaire d'une diode dl polarisée en inverse et est également reliée à la masse par l'intermédiaire d'une diode d1 polarisée en direct en série avec une diode à avalanche Z polarisée en inverse dont la tension de seuil est voisine (légèrement supérieure) de la tension haute sur la ligne. Ainsi, une surtension négative sur la ligne L s'écoule vers la masse par la diode d1 et une surtension positive, de valeur supérieure à la tension nominale de la ligne, s'écoule par la diode d'1 à travers la diode à avalanche Z.

Ce type de schéma de protection permet d'utiliser une diode de protection de faible tension d'avalanche et/ou de forte capacité d'absorption de surcharge et donc de grande dimension tout en limitant la capacité parasite rapportée sur le montage à protéger gràce à la présence des diodes d et d'.

En fait, dans les montages informatiques, on trouve un très grand nombre de lignes sur un connecteur et on est amené à leur associer de nombreux montages de protection du type de celui de la figure 1 présentant tous une même diode à avalanche en commun. Un tel montage est illustré en figure 2 où l'on trouve, en association avec chaque ligne L1 à L8, une diode d1 à d8 connectée en inverse vers la masse et une diode d'1 à d'8 connectée en direct par une diode à avalanche Z vers la masse.

Un mode de réalisation d'une intégration monolithique du circuit de la figure 2, dans lequel les diodes d1 à d8 et d'1 à d'8 sont des diodes de Schottky, a déjà été proposé par la demanderesse dans la demande de brevet européenne EP-A-562 982 publiée après la date de priorité de la présente publication.

La présente invention vise une réalisation sous forme de circuit monolithique du circuit de la figure 2 dans lequel les diodes d1 à d8 et d'1 à d'8 sont des diodes à jonction de sorte que le dispositif peut assurer une protection même pour un très fort niveau de courant.

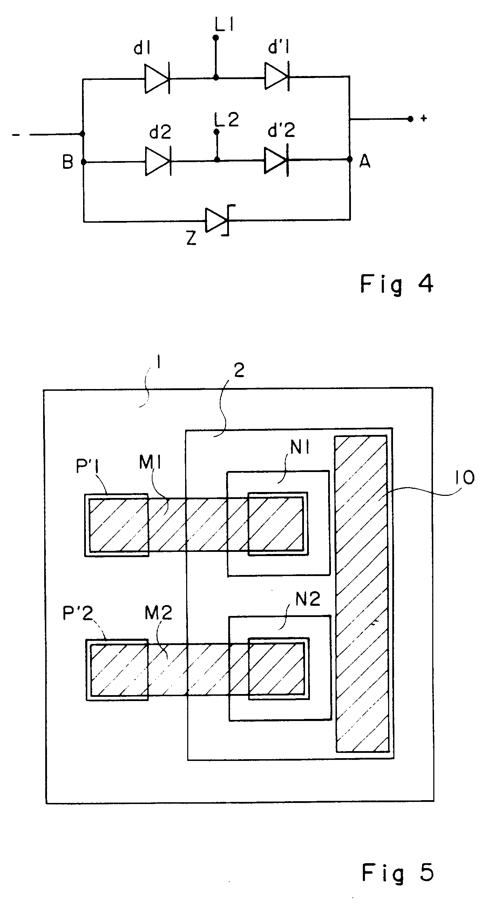

Plus généralement, on notera que le schéma de la figure 2 comprend une diode de protection Z aux bornes de laquelle est connectée une pluralité de paires de diodes, chaque paire de diodes comportant deux diodes orientées selon la même polarité que la diode de protection. Un tel schéma peut avoir d'autres applications que celle exposée précédemment de formation d'un réseau de diodes de protection. Par exemple, on verra en relation avec la figure 4 qu'un tel schéma est aussi celui d'un pont redresseur auto-protégé.

Ainsi, la présente invention vise de façon générale un composant monolithique incorporant une diode de protection en parallèle avec une pluralité de paires de diodes orientées selon la même polarité que cette diode de protection.

Un autre objet de la présente invention est de prévoir un tel composant susceptible d'absorber des surcharges importantes.

Ces objets sont atteints selon la présente invention par un composant monolithique selon la revendication 1.

Selon un mode de réalisation de la présente invention, le composant comprend en outre une troisième métallisation revêtant la face inférieure du substrat.

Selon un mode de réalisation de la présente invention, les premières régions, les murs d'isolement et la troisième région ont une épaisseur supérieure à la moitié de l'épaisseur du substrat.

Selon la revendication 4, la présente invention prévoit aussi d'utiliser le composant monolithique défini ci-dessus comme réseau de diodes de protection, chacune des premières métallisations étant reliée à une ligne à protéger et la deuxième métallisation étant reliée à une tension de référence, par exemple la masse.

Selon un autre aspect de la présente invention, les deuxième et troisième métallisations sont reliées à une source d'alimentation continue en série avec une résistance, la tension de la source d'alimentation étant inférieure à la tension d'avalanche de la diode de protection.

Selon la revendication 7, la présente invention prévoit aussi d'utiliser le composant monolithique défini ci-dessus comme pont redresseur auto-protégé pour une alimentation polyphasée à n phases, comprenant n premières régions et n deuxièmes régions, chaque i-ième, i étant compris entre 1 et n, première métallisation reliant la i-ième première région à la i-ième deuxième région étant reliée à une i-ième borne d'alimentation alternative, la deuxième métallisation constituant une borne d'alimentation continue, et la troisième métallisation constituant l'autre borne d'alimentation continue.

Ces objets, caractéristiques et avantages ainsi que d'autres de la présente invention seront exposés en détail dans la description suivante de modes de réalisation particuliers faite en relation avec les figures jointes parmi lesquelles :
les figures 1 et 2, décrites précédemment, représentent des schémas de circuit de réseaux de diodes de protection ;
la figure 3A représente une vue en coupe selon la ligne A-A de la figure 3B d'une structure selon la présente invention ;
la figure 3B représente une vue de dessus partielle de la structure de la figure 3A, mettant en oeuvre le schéma de la figure 2 ;
la figure 4 représente un schéma de circuit illustrant une autre application du composant monolithique selon la présente invention ;
la figure 5 représente une vue de dessus partielle d'une structure selon la présente invention mettant en oeuvre le schéma de la figure 4 ; et
la figure 6 illustre une variante d'utilisation d'un réseau de diodes de protection selon la présente invention.

De façon classique dans le domaine de la représentation des structures semiconductrices, les diverses vues en coupe et de dessus ne sont pas tracées à l'échelle et, dans les vues en coupe, les allures des contours des zones diffusées sont fortement schématiques.

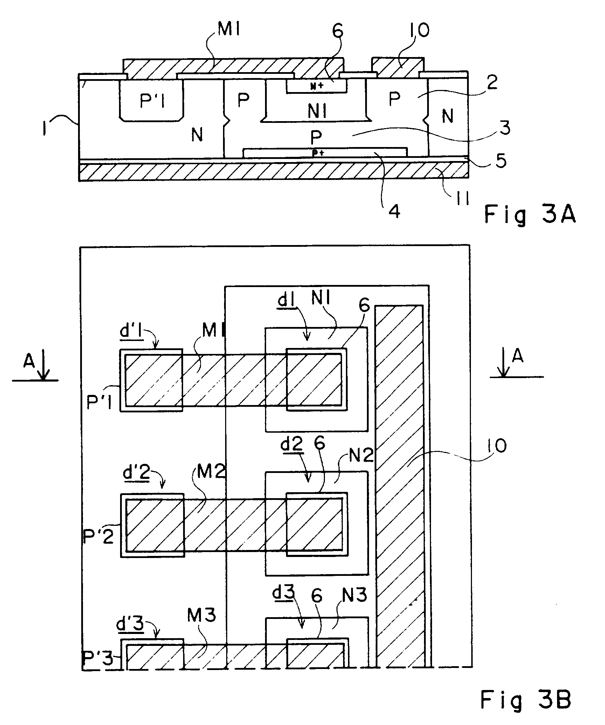

Comme le représentent les figures 3A et 3B, un réseau de protection monolithique selon la présente invention est formé à partir d'un substrat 1 d'un premier type de conductivité, par exemple de type N.

Les diodes d'1, d'2, d'3... résultent de la diffusion à partir d'une première face de ce substrat de régions de type P, P'1, P'2, P'3..., qui constituent les anodes de ces diodes. La cathode commune des diodes d'1, d'2, d'3... correspond au substrat 1.

Les cathodes N1, N2, N3... des diodes d1, d2, d3... sont constituées de régions du substrat 1, délimitées latéralement par un mur d'isolement 2 de type P, qui se terminent sur une région 3 également de type P formée à partir de la face inférieure du substrat. Cette région 3 de type P correspond à l'anode commune des diodes d1, d2, d3...

La diode à avalanche Z est formée à partir de la face inférieure du substrat. Elle a pour anode une région profonde 4 de type P⁺ formée dans la région 3 de type P et pour cathode une région 5 de type N⁺ qui est formée sur toute la face inférieure du substrat. C'est essentiellement le dopage de la région 4 qui détermine la tension d'avalanche. Bien que cela ne soit pas représenté dans la vue de dessus de la figure 3B, on comprendra que la région 3 de type P s'étend sensiblement sur toute la largeur et toute la longueur de la région d'ensemble délimitée en vue de dessus par le contour externe des murs d'isolement 2 et que la région 4 de type P⁺ a sensiblement la même étendue. Ainsi, la diode à avalanche a une surface de jonction beaucoup plus grande que celle de chacune des diodes d1, d2, d3... et d'1, d'2, d'3...

De préférence, une région 6 de type N⁺ est formée à la surface de chacune des régions N1, N2, N3... Des métallisations M1, M2, M3... relient chacune des régions P'1, P'2, P'3... à chacune des régions surdopées 6 formées dans les régions N1, N2, N3... Ces métallisations sont destinées à être reliées à chacune des lignes L1, L2, L3... de la figure 2. Une métallisation 10 est formée sur la surface du mur d'isolement 2 et correspond à la borne de connexion à la tension de référence REF, couramment la masse. Enfin, et de préférence, une métallisation 11 est formée sur l'ensemble de la face inférieure pour améliorer la conductivité entre les cathodes communes des diodes d'1, d'2, d'3... et la région de cathode 5 de la diode à avalanche située sous la région d'anode 4 de cette diode à avalanche. Dans l'application décrite jusqu'ici, la métallisation 11 est maintenue flottante.

Un procédé de fabrication de la structure des figures 3A et 3B comprend les étapes successives suivantes :
- formation simultanée à partir des faces supérieure et inférieure du substrat des régions P'1, P'2, P'3..., des murs d'isolement 2, et de la région 3. Cette étape de diffusion sera poursuivie suffisamment longtemps pour que les murs 2 formés à partir de la face supérieure rejoignent la région 3 formée à partir de la face inférieure. Ainsi, si le substrat a une épaisseur de 240 micromètres, la profondeur de diffusion sera supérieure à 120 micromètres ;
- formation à partir de la face inférieure de la région 4 de type P⁺ ;
- formation simultanée sur les faces supérieure et inférieure des régions 5 et 6 de type N⁺ ; et
- formation des métallisations.

Parmi les avantages de la structure selon l'invention, on notera qu'elle est adaptée à des passages de courants d'avalanche importants quelle que soit la polarité de la surcharge.
a) Si la métallisation ou borne M1 reçoit une surcharge positive par rapport à la borne M2, la diode d'1 est en direct, le courant circule de la région P'1 vers la métallisation de face inférieure 11 (figure 3A), circule dans la métallisation 11 en face de la région N2 (figure 3B) et remonte vers la métallisation M2 en traversant la jonction N⁺-P⁺ constituant la diode Z en inverse et la jonction P-N2 constituant la diode d2 en direction. On constate que les régions de silicium sont parcourues verticalement, sans présence de circulation "planar". Les diodes d'1, d2 et Z sont donc utilisées et se comportent comme des composants "discrets" et leur capacité d'écoulement est proportionnelle à leur taille.
b) Si la borne M1 reçoit une surcharge négative par rapport à M2, un mécanisme similaire se produit.
c) Si la borne M1 reçoit une surcharge positive par rapport à la masse 10, on a le même mécanisme qu'en a) si ce n'est que la diode d2 n'est pas sollicitée. Le courant remonte à travers les régions P 3-2 vers le contact 10.
d) Si la borne M1 est négative par rapport à la masse 10, le courant va circuler dans la diode latérale PN1N⁺ (figure 3A). Cependant, par construction, la région P délimitant le caisson est très dopée et enveloppe le caisson N1 ce qui diminue la résistance d'accès de la diode d1 dans cette configuration.

Dans ce qui précède, on a considéré une structure réalisée à partir d'un substrat de type N. On pourrait aussi envisager une variante de la présente invention dans laquelle tous les types de conductivité seraient inversés, c'est-à-dire où les régions P seraient remplacées par des régions N, et inversement. La structure à réaliser restant celle de la figure 1 ou 2, cela signifie que la borne REF correspond alors à la métallisation 11 (face inférieure). La diode d1 est constituée de régions N'1PP⁺, d2 de P⁺P1N et Z de N⁺P⁺. En ce cas, les trajets de courant dans les diverses régions sont toujours verticaux entre une métallisation M1, M2, M3... et la métallisation 11 (la métallisation 10 n'étant plus connectée). En conséquence, cette structure est celle qui, en protection basse tension sur une ligne +5V/0V par exemple, assurera la meilleure efficacité de protection (efficacité jugée en tenue en surcharge et en faible capacité parasite).

Selon un autre avantage de la présente invention, la taille de la diode Z est proportionnelle au nombre de sorties. Cela signifie que la capacité d'écoulement en surcharge de Z est "auto adaptée" au nombre de sorties.

Selon un autre avantage de la présente invention, le fait que les régions d'anode P'1, P'2, P'3... des diodes d'1, d'2, d'3... correspondent à des régions profondes entraîne que l'épaisseur de la région de cathode située en dessous est réduite. On réduit ainsi la résistance à l'état passant de ces diodes et par conséquent les surtensions à la mise en conduction de ces diodes.

La figure 4 illustre une autre application du composant selon l'invention. Cette figure reprend des éléments du schéma de la figure 2 dans le cas où il est prévu seulement quatre diodes d1, d'1, d2, d'2. L'homme de l'art notera que, si les lignes L1 et L2, auxquelles sont respectivement connectés les points de raccordement des diodes d1-d'1 et d2-d'2, sont reliées à deux bornes d'une tension d'alimentation alternative, le schéma correspond à celui d'un pont redresseur fournissant aux bornes A et B de la diode Z une tension alternative redressée, la borne A correspondant à la borne positive et la borne B à la borne négative. Le composant selon la présente invention constitue alors un pont redresseur auto-protégé par une diode à avalanche.

La figure 5 représente une vue de dessus schématique d'un circuit intégré constituant un mode de réalisation selon la présente invention du circuit de la figure 4. La figure 5 ne sera pas décrite en détail car elle reprend les mêmes notations que celles utilisées en figure 3B. Dans ce cas, les métallisations M1 et M2 correspondent aux bornes d'alimentation alternatives et la métallisation 10 ainsi que la métallisation de face arrière 11 correspondent aux bornes de courant continu.

La structure des figures 4 et 5 s'étend naturellement à la réalisation d'un pont polyphasé à n phases. Il est alors prévu n paires de diodes d1 ... di ... dn, d'1 ... d'i ... d'n, (i étant compris entre 1 et n) et n premières métallisations (Mi) reliant chaque i-ième première région (P'i) à chaque i-ième deuxième région (Ni) reliées à n bornes d'alimentation alternative. La deuxième métallisation (10) constitue une borne d'alimentation continue et la troisième métallisation (11) constitue l'autre borne d'alimentation continue.

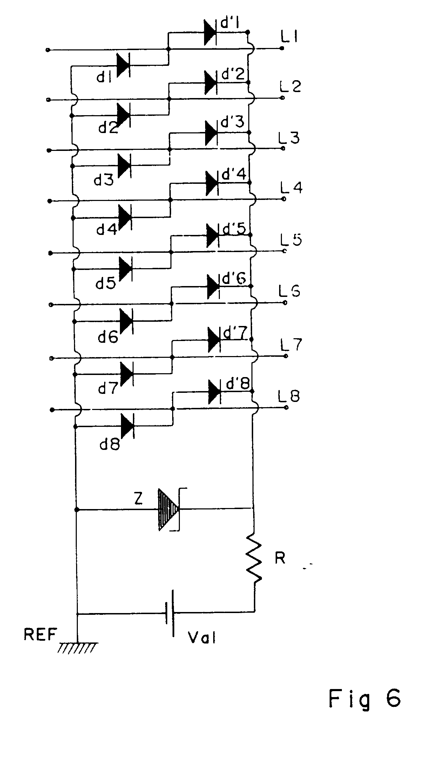

Une variante d'utilisation du composant de protection selon l'invention est illustrée en figure 6. Le composant est connecté à chacune des lignes L1 à L8 et de plus la diode Z est connectée à une alimentation Val à travers une impédance R.

Dans ce cas, comme précédemment, pour une surcharge négative entre une ligne et la masse, les tensions sont limitées à O V + la chute de tension en direct (Vf) d'une diode.

Par contre pour une surcharge positive par rapport au niveau REF ou pour une surcharge ligne/ligne, on obtient deux niveaux de protection.
- Pour des surcharges de faible amplitude la protection prend place à un niveau Val + Vf pour une surcharge positive par rapport au niveau REF, et à un niveau ± Val+Vf pour une surcharge ligne/ligne.
- Pour des surcharges de forte amplitude, la résistance R va élever la tension aux bornes de la diode Z et cette diode Z va limiter la tension à plus haut niveau. On peut ainsi, par exemple, obtenir un premier niveau près de 4 à 5 V (fixé par Val) et un deuxième à 6 ou 7 V fixé par VZ. Cette structure permet donc d'abord de protéger les circuits connectés aux lignes par sollicitation de l'alimentation Val puis de protéger l'alimentation elle-même si la perturbation est trop élevée.

Bien entendu, dans le cadre des revendications, la présente invention est susceptible de nombreuses variantes et modifications qui apparaîtront à l'homme de métier. Les topographies des diverses régions seront optimisées en fonction des résultats visés.

## Revendications

1. Composant monolithique, incorporant une diode de protection en parallèle avec chaque paire de diodes d'une pluralité de paires de diodes, les diodes de chaque paire étant connectées en série et orientées selon la même polarité que la diode de protection, comprenant un substrat semiconducteur (1) d'un premier type de conductivité, ayant une face supérieure et une face inférieure, comprenant :
des premières régions (P'1, P'2, P'3...) du deuxième type de conductivité formées dans une première portion du substrat et s'étendant à partir de la face supérieure du substrat ;
des deuxièmes régions (N1, N2, N3...) constituées de portions supérieures du substrat séparées de la première portion, et dont les faces latérales sont délimitées par un mur d'isolement (2) du deuxième type de conductivité et dont les fonds sont contigus à une troisième région (3) du deuxième type de conductivité ;
une quatrième région (4) du deuxième type de conductivité et à haut niveau de dopage s'étendant à partir de la face inférieure dans la troisième région (3) ;
une cinquième région (5) du premier type de conductivité et à haut niveau de dopage sur toute la face inférieure du substrat ;
des premières métallisations (M1, M2, M3...), chacune d'entre elles reliant une première région respective (P'1, P'2, P'3...) à une deuxième région respective (N1, N2, N3...) ; et
une deuxième métallisation (10) sur au moins une portion du mur d'isolement (2), chaque paire de diodes étant formée par la première portion du substrat, une première région, une deuxième région connectée à la première région de la paire de diodes par une première, métallisation, et par la troisième région, la diode de protection étant formée par la quatrième région et la cinquième région.

2. Composant monolithique selon la revendication 1, caractérisé en ce qu'il comprend en outre une troisième métallisation (11) revêtant la face inférieure du substrat.

3. Composant monolithique selon la revendication 1, caractérisé en ce que les premières régions, les murs d'isolement et la troisième région ont une épaisseur supérieure à la moitié de l'épaisseur du substrat.

4. Utilisation d'un composant monolithique selon l'une quelconque des revendications 1 à 3 comme réseau de diodes de protection, dans laquelle chacune des premières métallisations (M1, M2, M3... ) est reliée à une ligne à protéger et la deuxième métallisation (10) est reliée à une tension de référence (REF).

5. Utilisation d'un composant monolithique selon la deuxième revendication 4, dans laquelle la tension de référence est la masse.

6. Utilisation d'un composant monolithique selon la revendication 4 rattachée à la deuxième revendication 2, dans laquelle les deuxième et troisième métallisations (10, 11) sont reliées à une source d'alimentation continue (Val) en série avec une résistance (R), la tension de la source d'alimentation étant inférieure à la tension d'avalanche de la diode de protection.

7. Utilisation d'un composant monolithique selon la revendication 2 comme pont redresseur auto-protégé pour une alimentation polyphasée à n phases, le composant monolithique comprenant n premières régions et n deuxièmes régions, dans laquelle chaque i-ième, i étant compris entre 1 et n, première métallisation (Mi) reliant la i-ième première région (P'i) à la i-ième deuxième région (Ni) est reliée à une i-ième borne d'alimentation alternative, la deuxième métallisation (10) constitue une borne d'alimentation continue, et la troisième métallisation (11) constitue l'autre borne d'alimentation continue.

## Claims

1. A monolithic component, incorporating a protection diode in parallel with each pair of diodes of a plurality of pairs of diodes, the diodes of each pair being connected in series and oriented so as to have the same polarity as the protection diode, comprising a semiconductor substrate (1) of a first conductivity type, having an upper surface and a lower surface, including:
first regions (P'1, P'2, P'3...) of the second conductivity type that are formed in a first portion of the substrate and extending from the upper surface of the substrate;
second regions (N1, N2, N3...) constituted by upper portions of the substrate separated from the first portion and whose lateral surfaces are delineated by an insulating wall (2) of the second conductivity type, and whose bottoms are adjacent to a third region (3) of the second conductivity type;
a fourth highly doped region (4) of the second conductivity type extending from the lower surface in the third region (3);
a fifth highly doped region (5) of the first conductivity type on all the lower surface of the substrate;
first metallizations (M1, M2, M3... ), each of which connecting a respective first region (P'1, P'2, P'3...) to a respective second region (N1, N2, N3...); and
a second metallization (10) on at least one portion of the insulating wall (2), each pair of diodes being formed by the first portion of the substrate, a first region, a second region connected to the first region of the pair of diodes through a first metallization, and by the third region, the protection diode being formed by the fourth region and the fifth region.

2. The monolithic component of claim 1, characterized in that it further includes a third metallization (11) coating the lower surface of the substrate.

3. The monolithic component of claim 1, characterized in that the thickness of the first regions, of the insulating walls and of the third region is larger than half the thickness of the substrate.

4. Utilization of a monolithic component according to any of claims 1 to 3 as a protection diode array, in which each of the first metallizations (M1, M2, M3...) is connected to a line to be protected and wherein the second metallization (10) is connected to a reference voltage (REF).

5. The utilization of a monolithic component according to claim 4, wherein the reference voltage is the ground.

6. The utilization of a monolithic component according to claim 4, when dependent upon claim 2, wherein the second and third metallizations (10, 11) are connected to a d.c. power supply source (Val) in series with a resistor (R), the voltage of the power supply source being lower than the avalanche voltage of the protection diode.

7. Utilization of the monolithic component of claim 2 as a self-protected rectifying bridge for an n- phase power supply, including n first regions and n second regions, wherein each i-th (i being comprised between 1 and n) first metallization (Mi) connecting the i-th first region (P'i) to the i-th second region (Ni) is connected to an i-th a.c. supply terminal, the second metallization (10) constitutes a d.c. supply terminal, and the third metallization (11) constitutes the other d.c. supply terminal.

## Patentansprüche

1. Monolithisches Bauelement mit einer Schutzdiode, die parallel zu jedem Diodenpaar einer Vielzahl von Diodenpaaren geschaltet ist, wobei die Dioden jedes Paares in Serie geschaltet und in der gleichen Polarität wie die Schutzdiode ausgerichtet sind, mit einem Halbleitersubstrat (1) eines ersten Leitungstypes, welches eine Oberseite und eine Unterseite aufweist, mit folgenden Merkmalen:
- ersten Bereichen (P'1, P'2, P'3 ...) vom zweiten Leitungstyp, die in einem ersten Teilgebiet des Substrates ausgebildet sind und von der Oberseite des Substrates ausgehen;
- zweiten Bereichen (N1, N2, N3 ...) die in oberen Teilgebieten des Substrates gebildet sind und jeweils von dem ersten Teilgebiet getrennt sind und deren seitliche Flächen durch einen Isolationswall (2) des zweiten Leitungstypes begrenzt sind und deren Böden einen dritten Bereich (3) des zweiten Leitungstypes berühren;
- einem vierten Bereich (4) des zweiten Leitungstypes mit hoher Dotierung, der sich von der Unterseite in den dritten Bereich (3) erstreckt;
- einem fünften Bereich (5) des ersten Leitungstypes mit hoher Dotierung auf der gesamten Unterseite des Substrates;
- ersten Metallisierungen (M1, M2, M3...), von denen jede jeweils einen ersten Bereich (P'1, P'2, P'3 ...) mit einem zweiten Bereich (N1, N2, N3 ...) verbindet; und
- einer zweiten Metallisierung (10) über zumindst einem Teilgebiet des Isolationswalles (2), wobei jedes Diodenpaar durch das erste Teilgebiet des Substrates, einen ersten Bereich, einen zweiten, mit dem ersten Bereich des Diodenpaares über eine erste Metallisierung verbundenen zweiten Bereich und durch den dritten Bereich gebildet wird, wobei die Schutzdiode durch den vierten Bereich und den fünften Bereich gebildet wird.

2. Monolithisches Bauelement nach Anspruch 1, dadurch gekennzeichnet, daß es weiterhin eine dritte Metallisierung (11) aufweist, die die Unterseite des Substrates bedeckt.

3. Monolithisches Bauelement nach Anspruch 1, dadurch gekennzeichnet, daß die ersten Bereiche, die Isolationswälle und der dritte Bereich eine Dicke aufweisen, die größer als die halbe Dicke des Substrates ist.

4. Verwendung eines monolithischen Bauelementes nach einem der Ansprüche 1 bis 3 als Netz von Schutzdioden, wobei jede der ersten Metallisierungen (M1, M2, M3...) mit einer zu schützenden Leitung und die zweite Metallisierung (10) mit einer Referenzspannung (REF) verbunden sind.

5. Verwendung eines monolithischen Bauelementes nach Anspruch 4, wobei die Referenzspannung die Masse ist.

6. Verwendung eines monolithischen Bauelementes nach Anspruch 4 in Verbindung mit Anspruch 2, wobei die zweiten und dritten Metallisierungen (10, 11) mit einer Gleichspannungsquelle (Val) in Serie mit einem Widerstand (R) verbunden sind, wobei die Spannung der Gleichspannungsquelle niedriger als die Lawinenspannung der Schutzdiode ist.

7. Verwendung eines monolithischen Bauelementes nach Anspruch 2 als selbstschützende Gleichrichterbrücke für eine mehrphasige Spannungsquelle mit n-Phasen, wobei das monolithische Bauelement n erste Bereiche und n zweite Bereiche umfaßt, wobei jede i-ten - mit 1 als ganze Zahl zwischen 1 und n - erste Metallisierung (Mi), die den i-ten ersten Bereich (P'i) mit dem i-ten zweiten Bereich (Ni) verbindet, mit einem i-ten Wechselspannungsanschluss verbunden ist, wobei die zweite Metallisierung (10) einen Gleichspannungsanschluss bildet und die dritte Metallisierung den anderen Gleichspannungsanschluss bildet.
